# EUROPEAN PATENT SPECIFICATION

(11) **EP 3 911 138 B1**
(45) Date of publication and mention of the grant of the patent: **07.06.2023**
(21) Application number: 19909504.3
(22) Date of filing: 08.01.2019
(51) Int. Cl.: H05K 13/00, H05K 13/08

(54) **BACK-UP PIN STATE CONFIRMATION SYSTEM FOR COMPONENT MOUNTING APPARATUS**
SICHERUNGSSTIFTZUSTANDSBESTÄTIGUNGSSYSTEM FÜR BAUTEILMONTAGEVORRICHTUNG
SYSTÈME DE CONFIRMATION D'ÉTAT DE BROCHE DE SECOURS POUR APPAREIL DE MONTAGE DE COMPOSANT

(43) Date of publication of application: 17.11.2021
(73) Proprietor: Fuji Corporation, Chiryu-shi, Aichi 472-8686 (JP)
(72) Inventor: FUJIMOTO, Tomoya, Chiryu-shi, Aichi 472-8686 (JP); KOBAYASHI, Takahiro, Chiryu-shi, Aichi 472-8686 (JP); INAURA, Yuki, Chiryu-shi, Aichi 472-8686 (JP)
(74) Representative: Grünecker Patent- und Rechtsanwälte PartG mbB
(86) International application number: PCT/JP2019/000261
(87) International publication number: WO 2020/144748

(56) References cited:
- WO-A1-2014/136212
- WO-A1-2015/040755
- DE-A1-102014 205 701
- JP-A- H10 242 695
- JP-A- 2002 050 899
- JP-A- 2011 014 627

## Description

### Technical Field

The present specification discloses technology related to a backup pin state checking system of a component mounting machine equipped with a function which automatically exchanges the backup pins for supporting a circuit board from below, the circuit board being a board on which components are mounted.

### Background Art

Since component mounting boards in recent years are becoming thinner and easier to bend, circuit boards are supported by backup pins from below to prevent the circuit boards from bending when components are mounted on the circuit boards in component mounting machines. Further, as described in Patent Literature 1 (International Publication No. WO2015/040755), there is a component mounting machine on which an automatic exchanging function for the backup pins is installed in order to change the arrangement of the backup pins or change the type of the backup pins according to the type or size of the circuit board. Although this component mounting machine grips and exchanges the backup pin with a chuck or the like attached to a mounting head when automatically exchanging a backup pin, if the backup pin to be gripped is tilted by pressing on a foreign substance or the like on the backup plate on which the backup pin is placed, the grip of the backup pin may fail or the chuck or the like may interfere with the backup pin, and become damaged. In addition, when the automatically-exchanged backup pin is tilted by pressing on a foreign substance or the like on the backup plate, there may be a case where an effect of supporting the circuit board from below cannot be sufficiently achieved, or a component mounted on the underside face of the circuit board and the backup pin interfere with each other.

As described in Patent Literature 1, technology has been proposed for capturing an image of a backup pin by a camera from above and checking the state of the backup pin by image processing. In the method described in Patent Literature 1, a ring-shaped background portion that can be distinguished from the upper end of the backup pin in image processing and recognized in a distinguishable manner from the upper end of the backup pin is provided on the top face of a flange portion that protrudes in an annular manner on the outer periphery from a position below the upper end of the backup pin, wherein the upper end of the backup pin and the ring-shaped background portion are captured in the field of view of the camera from above, and the image is processed to recognize the ringshaped background portion around the outer periphery of the backup pin to determine whether the background portion appears in a complete ring shape (i.e., whether a portion of the background portion is hidden by the upper end of the backup pin) so as to determine whether the upper end of the backup pin is bent.

DE 10 2014 205701 A1 relates to determining the position and orientation of a plug contact. The tip of the plug can be illuminated from different directions and monitored with a line scan camera from above. The goal of this is to achieve robustness in determining the position and alignment of the plug tip by generating different images illuminated from different directions.

### Patent Literature

Patent Literature 1: International Publication WO2015/040755

### Summary of the Invention

### Technical Problem

If the backup pin is tilted, since the ring-shaped background portion is also tilted integrally with the backup pin, the background portion in the image captured by the camera from above does not form a complete ring shape but appears as an elliptical ring shape, the thickness of the elliptical ring shape not being constant, wherein the thickness in the tilted direction and the opposite direction at 180° are smaller. Moreover, since the outer diameter of the backup pin is small, it may be difficult to accurately detect, by image processing, that a part of the background portion of the elliptical ring is partially hidden when combined with the characteristic that the inclined background portion appears as an elliptical ring. In addition, given that there are various shapes and methods for gripping the backup pin, it may be difficult to provide, on the lower side of the upper end of the backup pin, a background portion that is ring-shaped when viewed from the camera side above.

The invention is defined by the features of the independent claims. Any reference to inventions or embodiments not falling within the scope of the independent claims are to be interpreted as examples useful for understanding the invention.

### Solution to Problem

In order to solve the above-mentioned problems, the backup pin state checking system of a component mounting machine of the present invention is a backup pin state checking system of a component mounting machine installed with a function for automatically exchanging a backup pin configured to support, from below, a circuit board on which components are mounted, the backup pin state checking system comprising:a camera configured to capture an image of the backup pin from above, and an image processing device configured to process the image captured by the camera;characterized in that wherein a protrusion is provided at each of three or more positions at a predetermined dimension below the upper end of the outer periphery of the backup pin; and the image processing device processes the image captured from above, the image including the backup pin and the three or more protrusions so as to be made to fall within the camera's field of view, to recognize, within the image, information regarding a length of a portion of each protrusion that is not hidden by the upper end of the backup pin, and determines whether the backup pin is tilted by a predetermined angle or more based on the image recognition result.

Also according to the invention, there is a backup pin state checking system of a component mounting machine installed with a function for automatically exchanging a backup pin configured to support, from below, a circuit board on which components are mounted, the backup pin state checking system comprising:a camera configured to capture an image of the backup pin from above, and an image processing device configured to process the image captured by the camera;characterized in that wherein a protrusion is provided at each of three or more positions at a predetermined dimension below the upper end of the outer periphery of the backup pin; and the image processing device processes the image captured from above, the image including the backup pin and the three or more protrusions so as to be made to fall within the camera's field of view, to recognize, within the image, information regarding a length of a portion of each protrusion that is not hidden by the upper end of the backup pin, and determines whether the backup pin is tilted by a predetermined angle or more based on the image recognition result.

In this case, since the inclination of the backup pin by a predetermined angle or more is determined based on an image recognition result of the information regarding the length of a portion of each protrusion that is not hidden by the upper end of the backup pin by capturing an image, from above with a camera, of three or more protrusions provided on the outer periphery of the upper end of the backup pin, the inclination of the backup pin by a predetermined angle or more can be accurately determined.

Here, the method for recognizing the information regarding the length may measure, for example, the length to the distal end of the protrusion not hidden by the upper end of the backup pin, may recognize whether a mark provided at a predetermined position on the top face of each protrusion is not hidden by the upper end of the backup pin, or may recognize the shade or color of a portion of a gradation portion in which the shade or color changes continuously or stepwise and is not hidden by the upper end of the backup pin.

### Brief Description of Drawings

Fig. 1 is a front view showing a normal installation state of a backup pin on a backup plate of a first embodiment.
Fig. 2 is a top view of the backup pin shown in Fig. 1.
Fig. 3 is a front view showing an inclined installation state of the backup pin on the backup plate.
Fig. 4 is a top view of the backup pin shown in Fig. 3.
Fig. 5 is a perspective view showing a component mounting station of a component mounting machine.
Fig. 6 is a block diagram showing a configuration of a control system of the component mounting machine.
Fig. 7 is a top view of a backup pin having no inclination in a second embodiment.
Fig. 8 is a top view of a backup pin having an inclination in the second embodiment.
Fig. 9 is a top view of a backup pin having no inclination in a third embodiment.
Fig. 10 is a top view of a backup pin having an inclination in the third embodiment.
Fig. 11 is a top view of a backup pin having no inclination in a fourth embodiment.
Fig. 12 is a top view of a backup pin having an inclination in the fourth embodiment.

### Description of Embodiments

The first to fourth embodiments disclosed herein will be described below.

### First embodiment

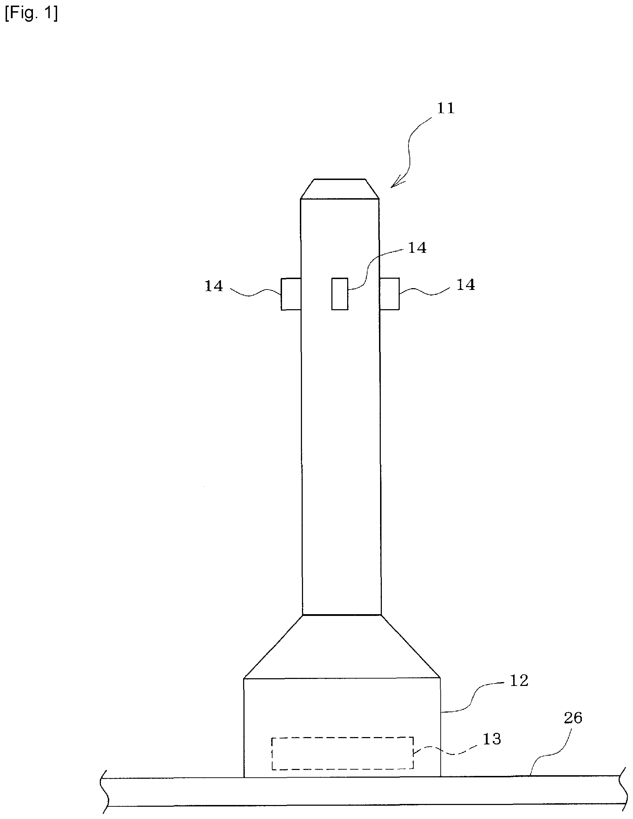

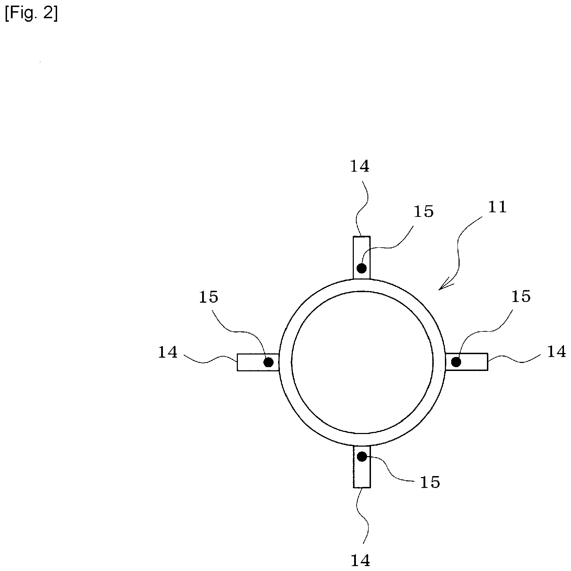

A first embodiment will be described with reference to Figs. 1 to 6. First, the configuration of backup pin 11 will be described with reference to Figs. 1 and 2.

Base section 12 for supporting backup pin 11 in a vertical state is provided at the lower portion of backup pin 11. Base section 12 is provided with magnet 13 for holding backup pin 11 by magnetic force on a backup plate 26 (described later).

Protrusions 14 are provided at equal angular intervals (90° intervals in the present embodiment 1) at three or more positions (four positions in the present first embodiment) at a predetermined dimension below the upper end of the outer periphery of backup pin 11. Each protrusion 14 has the same shape and the same dimension and is also used as an engagement protrusion for engaging and holding backup pin 11 in a bayonet engagement manner with an engagement holding tool (not shown) that is attached in an exchangeable manner to a mounting head (not shown) of a component mounting machine.

The top face of each protrusion 14 is a horizontal plane, and mark 15 indicating information as to the length from the outer peripheral surface of backup pin 11 (or the length to the distal end of protrusion 14) is provided at a position, within the top face of protrusion 14, separated by a predetermined dimension from the outer peripheral surface of backup pin 11. In the first embodiment, marks 15 are provided at 90° intervals at four positions located concentrically with backup pin 11. Each mark 15 may have any shape, such as a small circle or a square, regardless of color or material, as long as mark 15 can be image-recognized. In addition, each mark 15 may be provided on the top face of each protrusion 14 by ink jet printing, coating, stamping, or the like, or may be provided as a sticker or the like so as to change the position and/or shape or the like of mark 15 on the top face of each protrusion 14.

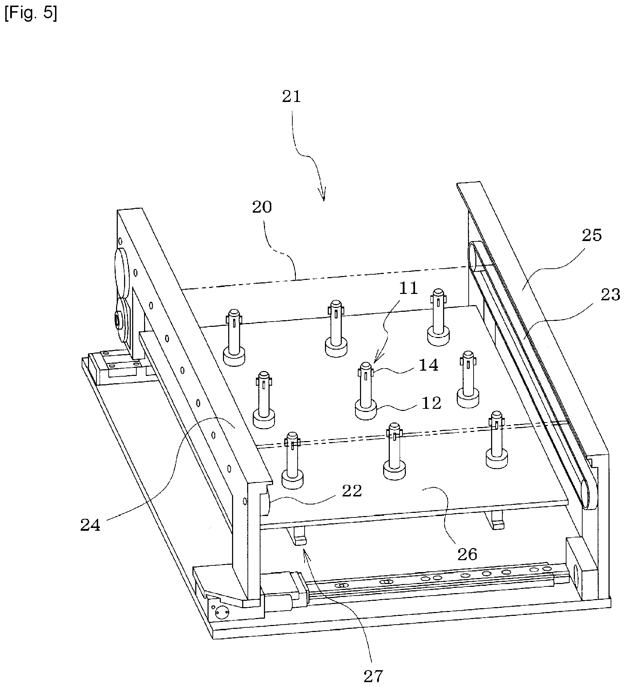

Next, a configuration of component mounting station 21 of the component mounting machine will be described with reference to Fig. 5. Component mounting station 21 is a location where a component is mounted, by a mounting head of the component mounting machine, on circuit board 20 conveyed in by conveyors 22, 23. Conveyors 22, 23 are arranged in parallel with the conveyance direction of circuit board 20 so that the left and right sides of circuit board 20 can be placed and conveyed, rail 25 holding right conveyor 23 is a reference rail whose position is fixed, and rail 24 holding left conveyor 22 is a movable rail that moves in the width direction in accordance with the width of circuit board 20.

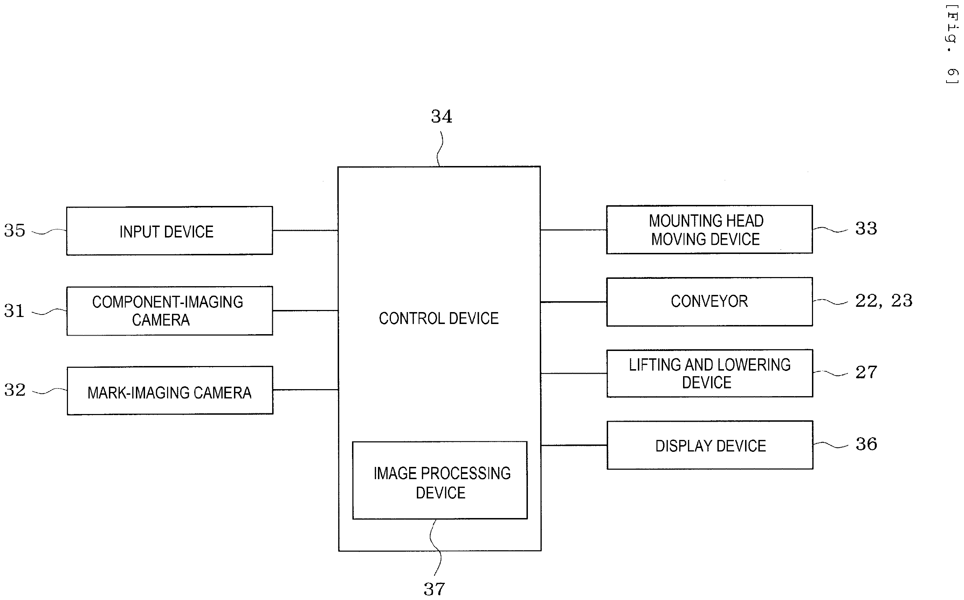

Backup plate 26 on which backup pin 11 is placed is provided horizontally in component mounting station 21. Backup plate 26 is made of a magnetic material such as iron so that backup pin 11 is attracted to and held on backup plate 26 by magnet 13. Backup plate 26 is configured to be lifted and lowered by a lifting and lowering device 27 (see Fig. 6) so that backup plate 26 rises to the upper limit position when clamping circuit board 20 that has been conveyed in, and backup plate 26 falls to the lower limit position when the clamping of circuit board 20 is released.

In the first embodiment, the size of backup plate 26 is larger than the size of circuit board 20, a portion of backup plate 26 protruding from a position directly below circuit board 20 is used as a backup pin storage section, and backup pin 11 to be automatically exchanged is placed on the backup pin storage section for storage. It should be noted that the backup pin storage may be provided at a different location from backup plate 26 (e.g., in the vicinity of conveyors 22, 23), and in short, may be provided in an area where the engagement holding tool held by the mounting head is movable.

As shown in Fig. 6, the component mounting machine is provided with component-imaging camera 31, for capturing an image of a component picked up by a suction nozzle (not shown) held by the mounting head from the lower face thereof, and mark-imaging camera 32, for capturing an image of a reference position mark (not shown) of circuit board 20. Mark-imaging camera 32 is integrally moved with the mounting head by mounting head moving device 33 and is also used as a camera for capturing an image of backup pin 11 placed on backup plate 26 or the backup pin storage section from above. For the lens of mark-imaging camera 32, a telecentric lens that is not affected by image distortion or the like due to parallax is used to accurately detect the inclination of backup pin 11 which will be described later.

Input device 35 such as a keyboard, a mouse, a touch panel, or the like, display device 36 such as an LCD, an EL, a CRT, or the like are connected to control device 34 of the component mounting machine. In addition, control device 34 accommodates image processing device 37 for processing an image captured by component-imaging camera 31 or mark-imaging camera 32.

Control device 34 of the component mounting machine is configured primarily by one or more computers (CPUs) and controls the operation of mounting components on circuit boards 20 by controlling each operation of the component mounting machine. Further, when exchanging backup pin 11 or changing the arrangement of backup pins 11, control device 34 controls the up-down-left-right movement and the up-down and rotating operations of the engagement holding tool attached to the mounting head and the imaging operation of mark-imaging camera 32, thereby controlling the operation of exchanging backup pins 11 between the backup pin storage section and backup plate 26, or changing the arrangement of backup pins 11 on backup plate 26. At this time, backup pin 11 to be engaged and held by the engagement holding tool and protrusions 14 around backup pin are made to fall within the field of view of mark-imaging camera 32 and imaged from above, the image is processed by image processing device 37 to recognize the positions of protrusions 14 of backup pin 11, the engagement holding tool is positioned above the positions of protrusions 14 of backup pin 11, and the engagement holding tool engages with protrusions 14 of backup pin 11 by performing a lowering and rotating operation.

Further, when processing an image captured by mark-imaging camera 32 from above backup pin 11 and each protrusion 14 around backup pin 11, image processing device 37 recognizes the image of the mark 15 of each protrusion 14, and determines whether or not any of the mark portions 15 of each protrusion 14 is hidden at the upper end portion of the backup pin 11 based on the image recognition result, thereby determining whether or not the inclination of the backup pin 11 by no less than a predetermined angle.

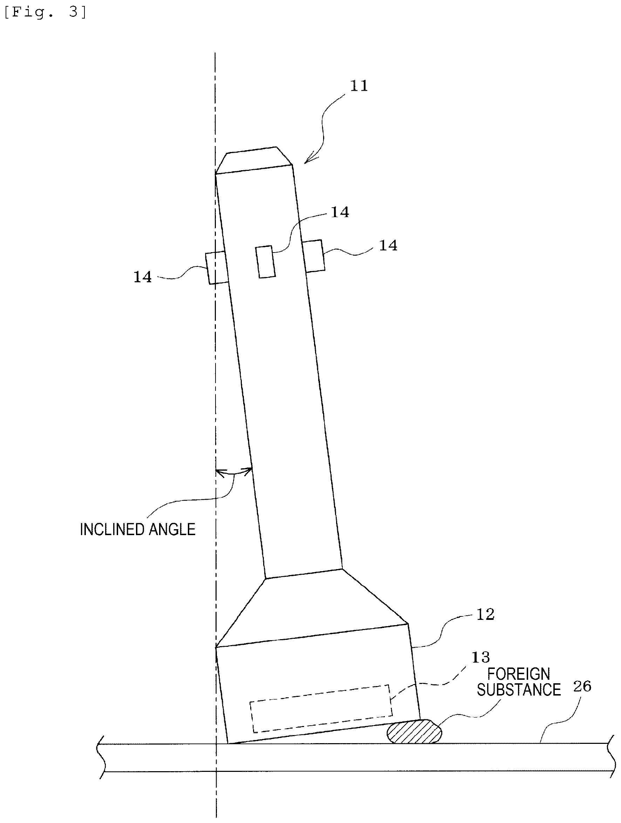

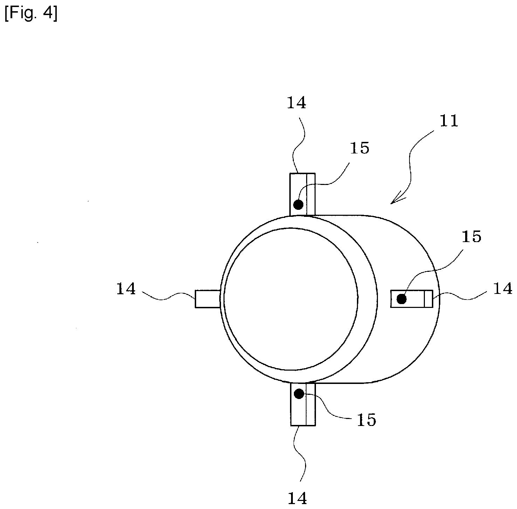

As shown in Fig. 3 and Fig. 4, when backup pin 11 is tilted by pressing on a foreign substance or the like on backup plate 26 or the backup pin storing section to such an extent that the inclination angle causes a failure to engage and hold backup pin 11, mark 15 of protrusion 14 closest to the inclined direction side is hidden by the upper end of backup pin 11 when viewed from above, that is, the side of mark-imaging camera 32. In other words, mark 15 is provided at a position where it is hidden by the upper end of backup pin 11 and is not visible when the inclination angle has reached an extent at which engaging and holding backup pin 11 fails.

Accordingly, when there is protrusion 14 concealed by the upper end of backup pin 11, for which recognizing mark 15 is not possible based on the image recognition result, image processing device 37 determines that backup pin 11 is tilted by a predetermined angle or more. In this case, control device 34 does not perform the operation of engaging and holding backup pin 11 but displays backup pin 11 on display device 36 or a portable terminal (not shown) of an operator, or notifies the operator by sound.

In this case, the process may shift to automatic exchanging of the next backup pin 11, or stopping the automatic exchanging of all backup pins 11 until the operator manually corrects the inclination of backup pin 11 whose inclination has been detected.

In the first embodiment described above, since four protrusions 14 provided on the outer periphery below the upper end of backup pin 11 are captured by mark-imaging camera 32 from above, and it is determined whether backup pin 11 is tilted by a predetermined angle or more based on whether mark 15 of each protrusion 14 that is not hidden by the upper end of backup pin 11 can be recognized, it is possible to accurately determine whether backup pin 11 is tilted by a predetermined angle or more.

In addition, since four protrusions 14 provided around the outer periphery of backup pin 11 use engagement protrusions that engage and hold backup pin 11 with the engagement holding tool attached to the mounting head of the component mounting machine, mark 15 can be easily formed even on an existing backup pin having the engagement protrusions, giving the inclination detecting technique of the first embodiment the advantage of being capable of implementing at a low cost.

### Second embodiment

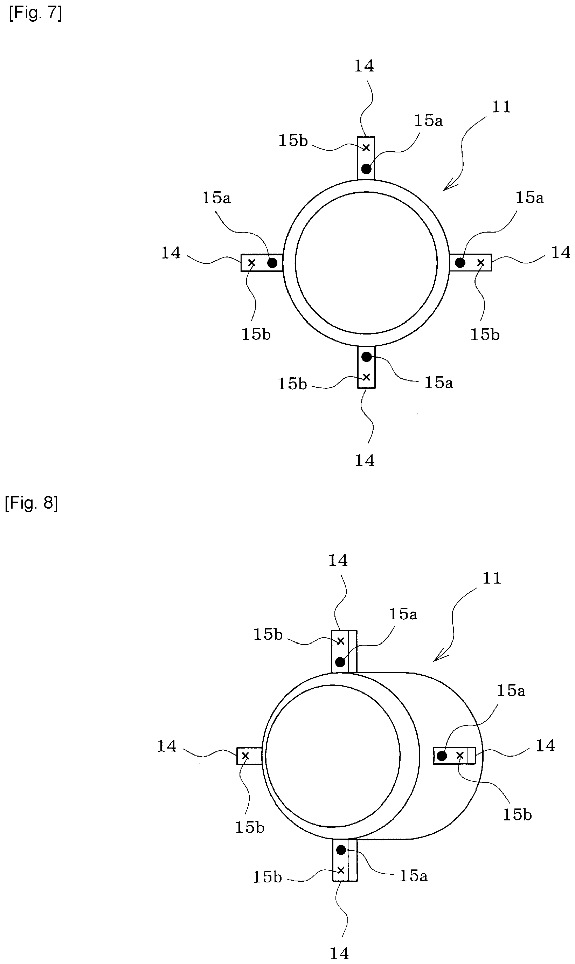

Next, a second embodiment will be described with reference to Fig. 7 and Fig. 8. The same reference numerals are actually assigned to the same portions as in the first embodiment, and descriptions thereof will be omitted or simplified and will mainly focus on the portions that are different.

In the first embodiment, one mark 15 is provided on the top face of each protrusion 14, whereas in the second embodiment shown in Figs. 7 and 8, multiple marks 15a, 15b are provided on the top face of each protrusion 14. Mark portions 15a, 15b of each protrusion 14 are respectively located on concentric circles about the axial center of backup pin 11, and the distances of marks 15a, 15b from the outer peripheral surface of backup pin 11 are set to the same distances for all protrusions 14. In the second embodiment shown in Fig. 7 and Fig. 8, two marks 15a, 15b are provided for each protrusion 14, but three or more marks 15a, 15b may be provided for each protrusion 14. The shapes of marks 15a, 15b may be different from each other as long as the shapes can be image-recognized. Each of markings 15a, 15b may be provided on the top face of each protrusion 14 by inkjet printing, coating, stamping, or the like, or may be provided as a sticker or the like so as to change the position, number, shape, or the like of marks 15 on the top face of each protrusion 14.

As in the second embodiment, when multiple markings 15a, 15b are provided on each protrusion 14, the number of marks 15a, 15b, among multiple marks 15a, 15b of protrusion 14, hidden by the upper end of backup pin 11 when viewed from the mark-imaging camera 32 side above backup pin 11 increases as the inclination angle of backup pin 11 increases. In other words, the number of marks 15a, 15b (i.e., the number of marks 15a, 15b that can be image-recognized), among marks 15a, 15b of protrusion 14, that are not hidden by the upper end of backup pin 11 decreases as the inclination angle of backup pin 11 increases.

Therefore, in the second embodiment, when processing an image captured of backup pin 11 and each protrusion 14 around backup pin 11 from above by mark-imaging camera 32, image processing device 37 determines the inclination angle of backup pin 11 based on the recognition result by recognizing the number of marks 15a, 15b, among marks 15a, 15b of each protrusion 14, that are not hidden by the upper end of backup pin 11.

Further, when it is determined based on the image recognition result of image processing device 37 that the inclination angle of backup pin 11 is equal to or greater than the inclination angle at which engaging and holding of backup pin 11 fails, control device 34 does not perform the operation of engagement and retention of the backup pin 11 but displays backup pin 11 on display device 36 or a portable terminal of an operator, or notifies the operator by sound.

Further, when it is determined that the inclination angle of backup pin 11 is a small inclination angle at which engaging and holding backup pin 11 is possible based on the image recognition result of image processing device 37, control device 34 performs the operation of engaging and holding backup pin 11, but may display the fact that there is a small inclination on display device 36 or the portable terminal of the operator, or notify the operator by sound to prompt the operator to clean backup plate 26.

In the second embodiment described above, since multiple marks 15a, 15b are provided on each protrusion 14, when processing an image captured of backup pin 11 and each protrusion 14 around backup pin 11 from above by mark-imaging camera 32, the inclination angle of backup pin 11 can be determined by imaging the number of marks 15a, 15b, among multiple marks 15a, 15b of each protrusion 14, not hidden by the upper end of backup pin 11. In addition, it is possible to obtain the same effect as in the first embodiment.

### Third embodiment

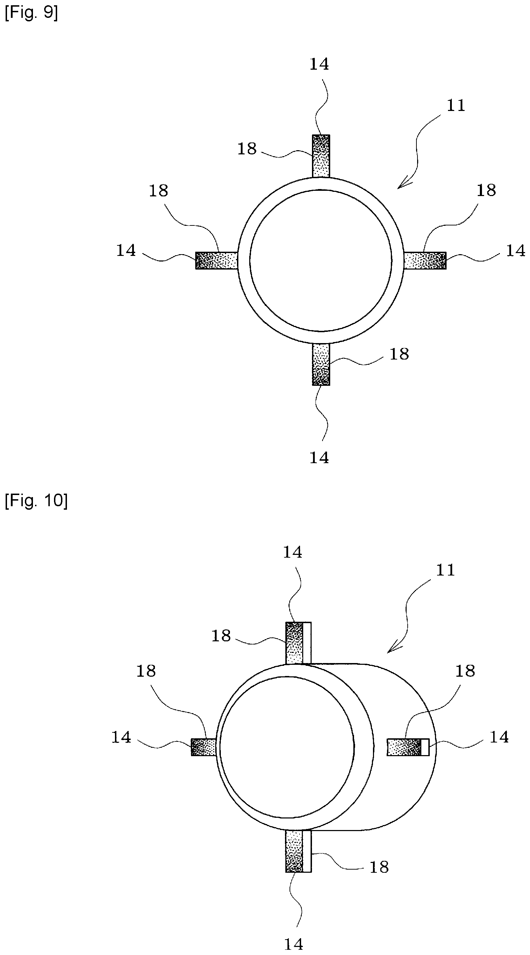

Next, a third embodiment will be described with reference to Figs. 9 and 10. The same reference numerals are actually given to the same portions as in the first and second embodiments, and description thereof will be omitted or simplified and will mainly focus on the portions that are different.

In the first and second embodiments, one or more marks 15 are provided on the top face of each protrusion 14, whereas in the third embodiment shown in Figs. 9 and 10, gradation portions 18 whose shade or color changes continuously or stepwise as the distance from the outer peripheral surface of backup pin 11 increases is provided on the top face of each protrusion 14. Each gradation portion 18 is used as information indicating the length from the outer peripheral surface of backup pin 11 (or the length to the distal end of protrusion 14). Gradation portion 18 may be provided on the top face of each protrusion 14 by ink jet printing, coating, stamping, or the like, or may be provided on the top face of each protrusion 14 as a sticker or the like so as to enable exchanging with a different gradation portion.

For mark-imaging camera 32 used for imaging gradation portion 18, a camera for imaging a gray scale image (monochrome image) may be used when imaging gradation portion 18 in which the shading changes continuously or stepwise, whereas a camera for imaging a color image is used when imaging gradation portion 18 in which the color changes continuously or stepwise.

In the third embodiment, when processing an image captured of backup pin 11 and each protrusion 14 by mark-imaging camera 32 from above, image processing device 37 recognizes the shade or color of the portion, among gradation portions 18 of each protrusion 14, that is not hidden by the upper end of backup pin 11 (particularly the portion closer to the outer peripheral surface of backup pin 11) and determines the inclination angle of backup pin 11 based on the image recognition result.

Also in the third embodiment described above, it is possible to obtain the same effect as in the second embodiment.

### Fourth embodiment

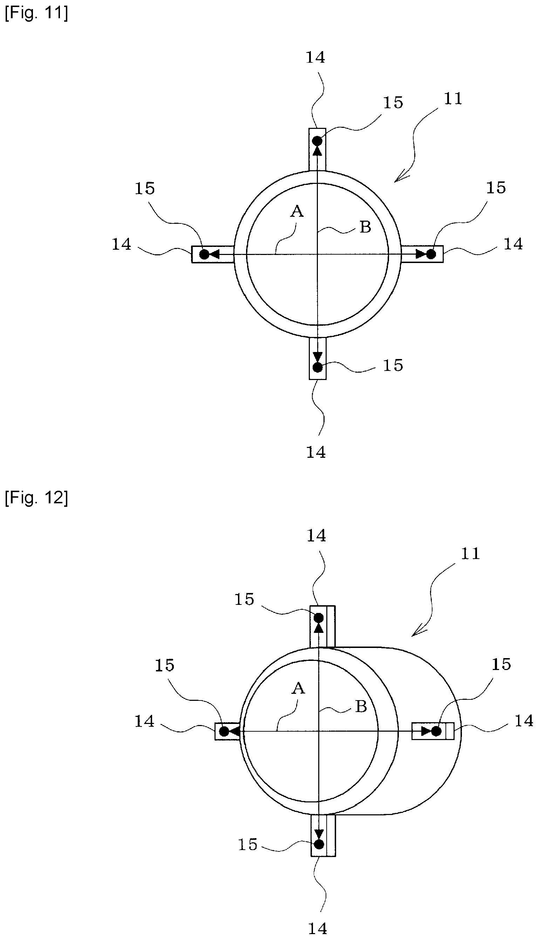

Next, a fourth embodiment will be described with reference to Figs. 11 and 12. The same reference numerals are actually assigned to the same portions as in the first embodiment, and descriptions thereof will be omitted or simplified and will mainly focus on the portions that are different.

In the first embodiment, backup pin 11 and protrusions 14 around the outer periphery of backup pin 11 are made to fall within the field of view of mark-imaging camera 32, the image captured from above is processed by image processing device 37 to image-recognize mark 15, which is information indicating the length of a portion of protrusion 14 not hidden by the upper end of backup pin 11, and it was determined whether the inclination of backup pin 11 is equal to or greater than a predetermined angle based on the image recognition result.

On the other hand, in the fourth embodiment shown in Fig. 11 and Fig. 12, backup pin 11 and each mark 15 around the outer periphery of backup pin 11 are made to fall within the field of view of mark-imaging camera 32, an image captured from above is processed by image processing device 37, the position (i.e., the coordinates) of each mark 15 is recognized, and the inclination angle of backup pin 11 is determined by measuring the distances between marks 15. In this case, the position of mark 15 provided on the top face of each protrusion 14 is provided at a position farther from the outer peripheral surface of backup pin 11 than the position of mark 15 of the first embodiment so that mark 15 does not become hidden by the upper end of backup pin 11 even if the inclination angle of backup pin 11 is increased to some extent.

Further, in the fourth embodiment, marks 15 are provided at 90° intervals at four positions located concentric with backup pin 11, and the distances A and B between the two sets of marks 15 located on both diameter directions of backup pin 11, that is, the distances A and B between marks 15 in two orthogonal directions are measured to determine the inclination angle of backup pin 11.

In this case, although the distances A and B between marks 15 in the two directions are equal if there is no inclination of backup pin 11, when there is inclination of backup pin 11, at least one of the distances A and B between marks 15 in the two directions is shorter than that of a case when there is no inclination of backup pin 11, and this length is shorter as the inclination angle of backup pin 11 increases. From this relationship, the inclination angle of backup pin 11 can be determined by measuring the distances A and B between marks 15 in the two directions. Also in the fourth embodiment described above, it is possible to obtain the same effects as those in the second and third embodiments.

It should be noted that the number of marks 15 (protrusions 14) is not limited to four, and may be three or more, and is not limited to the distances A and B between marks 15 located on both diameter directions of backup pin 11, and the inclination angle of backup pin 11 may be determined by measuring the distance between adjacent marks 15 or measuring the distances between three or more sets of marks 15.

### [Other Embodiments]

In the first to fourth embodiments described above, engagement protrusions that engage and hold backup pin 11 in a bayonet engagement manner with the engagement holding tool attached to the mounting head are used as three or more protrusions 14 provided on the outer periphery of backup pin 11, but each protrusion may be newly formed at three or more locations around the outer periphery of backup pin 11. Even in a case where each protrusion is newly formed, compared with the case where a background portion is formed, below the upper end of the backup pin, having a circular ring shape when viewed from the camera side above as in Patent Literature 1, there are fewer structural constraints and is easily formed.

In addition, the configuration for engaging and holding backup pin 11 is not limited to an engagement holding tool attached to the mounting head configured to engage and hold backup pin 11 in a bayonet engagement manner, and backup pin 11 may be held by a chuck or the like attached to the mounting head.

Further, in the first to fourth embodiments, marks 15, 15a, 15b and gradation portion 18 are provided on the top face of protrusion 14 as a means for indicating the length of a portion that is not hidden by the upper end of backup pin 11, but the length to the distal end of the portion, among protrusions 14, that is not hidden by the upper end of backup pin 11 may be measured by image processing.

In addition, the present invention is not limited to the first to fourth embodiments, and it is needless to say that the present disclosure can be variously changed within the limits of the appended claims.

### Reference Signs List

11... Backup pin 12... Base portion 13... Magnet 14... Protrusion 15,15a,15b... Mark 18... Gradation portion 20... Circuit board 21... Component mounting station 22, 23... Conveyor 26... Backup plate 32... Mark-imaging camera 34... Control device 36... Display device 37... Image processing device

## Claims

1. A backup pin (11) state checking system of a component mounting machine installed with a function for automatically exchanging a backup pin (11) configured to support, from below, a circuit board on which components are mounted, the backup pin (11) state checking system comprising:
a camera (32) configured to capture an image of the backup pin (11) from above, and
an image processing device (37) configured to process the image captured by the camera (32);
**characterized in that**
wherein a protrusion (14)is provided at each of three or more positions at a predetermined dimension below the upper end of the outer periphery of the backup pin (11); and
the image processing device (37) configured to process the image captured from above, the image including the backup pin (11) and the three or more protrusions (14) so as to be made to fall within the camera's (32) field of view, to recognize, within the image, information regarding a length of a portion of each protrusion (14) that is not hidden by the upper end of the backup pin (11), and to determine whether the backup pin (11) is tilted by a predetermined angle or more based on the image recognition result.

2. The backup pin (11) state checking system of the component mounting machine of claim 1, wherein a mark indicating information regarding the length is provided at a position within the top face of each protrusion (14), the position of which being separated by a predetermined dimension from the outer peripheral surface of the backup pin (11); and the image processing device (37) configured to determine whether the backup pin (11) is tilted by a predetermined angle or more by determining whether a mark on any of the protrusions (14) is hidden by the upper end of the backup pin (11) based on the image recognition result.

3. The backup pin (11) state checking system of the component mounting machine of claim 2, wherein multiple marks are provided on the top face of each protrusion (14) in a way such that positions of which are respectively located on multiple concentric circles around the axial center of the backup pin (11);
the image processing device (37) configured to recognize the number of marks, among the multiple marks of each protrusion (14), that are not hidden by the upper end of the backup pin (11), and determines the inclination angle of the backup pin (11) based on the image recognition result.

4. The backup pin (11) state checking system of the component mounting machine of claim 2 or 3, wherein the mark is provided such that at least one of the position with respect to the top face of each protrusion (14), the number, and the shape can be changed.

5. The backup pin (11) state checking system of the component mounting machine of claim 1, wherein
a gradation portion, shade or color of which changing continuously or stepwisely as the distance from the outer peripheral surface of the backup pin (11) increases, is provided on the top face of each protrusion (14) to indicate information regarding the length; and
the image processing device (37) configured to recognize the shade or color of the portion, within the gradation portion of each protrusion (14), that is not hidden by the upper end of the backup pin (11) and to determine the inclination angle of the backup pin (11) based on the image recognition result.

6. The backup pin (11) state checking system of the component mounting machine of claim 5, wherein the gradation portion is provided to the top face of each protrusion (14)in an exchangeable manner with a different gradation portion.

7. The backup pin (11) state checking system of the component mounting machine of any one of claims 1 to 6, wherein the image processing device (37) configured to determine the inclination direction of the backup pin (11) based on the image recognition result.

8. The backup pin (11) state checking system of the component mounting machine of any one of claims 1 to 7, wherein the component mounting machine holds the backup pin (11) by causing an engagement holding tool attached to the mounting head to engage with the protrusions (14) when the backup pin (11) is automatically exchanged.

9. The backup pin (11) state checking system of the component mounting machine of any one of claims 1 to 8, wherein
the camera (32) is a mark-imaging camera (32) configured to image a reference position mark of the circuit board, the component mounting machine is configured to capture an image of the backup pin (11) and the three or more protrusions (14) which are made to fall within the camera's (32) field of view from above when automatically exchanging the backup pin (11), and
when the image processing device (37) determines that the backup pin (11) is tilted by a predetermined angle or more based on the image recognition result, the operation for holding the backup pin (11) is not performed and the backup pin (11) is displayed and/or an operator is notified by sound.

10. A backup pin (11) state checking system of a component mounting machine, installed with a function for automatically exchanging a backup pin (11) configured to support, from below, a circuit board on which components are mounted, comprising:
a camera (32) configured to capture an image of the backup pin (11) from above; and
an image processing device (37) configured to process the image captured by the camera (32);
**characterized in that**
a mark is provided at each of three or more locations, at the same height, of the outer periphery of the backup pin (11); and
the image processing device (37) configured to process an image captured from above of the backup pin (11) and the three or more marks which are made to fall within the camera's (32) field of view, to recognize the position of each mark, and to determine the inclination angle of the backup pin (11) by measuring the distances between the marks.

11. The backup pin (11) state checking system of the component mounting machine of claim 3 or 10, wherein the marks are provided at 90° intervals at four positions located concentrically around the backup pin (11).

## Patentansprüche

1. Zustandsprüfungssystem für einen Stützstift (11) einer Bauteilmontagemaschine, die mit einer Funktion zum automatischen Auswechseln eines Stützstiftes (11) ausgestattet ist, der so konfiguriert ist, dass er eine Leiterplatte, auf der Bauteile montiert sind, von unten stützt, wobei das Zustandsprüfungssystem für den Stützstift (11) Folgendes umfasst:
eine Kamera (32), die so konfiguriert ist, dass sie ein Bild des Stützstifts (11) von oben erfasst, und
eine Bildverarbeitungsvorrichtung (37), die so konfiguriert ist, dass sie das von der Kamera (32) aufgenommene Bild verarbeitet;
**dadurch gekennzeichnet, dass**
ein Vorsprung (14) an jeder von drei oder mehr Positionen in einer vorbestimmten Abmessung unterhalb des oberen Endes des Außenumfangs des Stützstifts (11) bereitgestellt ist; und
die Bildverarbeitungsvorrichtung (37) so konfiguriert ist, dass sie das von oben aufgenommene Bild verarbeitet, wobei das Bild den Stützstift (11) und die drei oder mehr Vorsprünge (14) enthält, so dass sie in das Sichtfeld der Kamera (32) fallen, um innerhalb des Bildes Informationen bezüglich einer Länge eines Abschnitts jedes Vorsprungs (14) zu erkennen, der nicht durch das obere Ende des Stützstifts (11) verdeckt ist, und um auf der Grundlage des Bilderkennungsergebnisses zu bestimmen, ob der Stützstift (11) um einen vorbestimmten Winkel oder mehr gekippt ist.

2. Zustandsprüfungssystem für den Stützstift (11) der Bauteilmontagemaschine nach Anspruch 1, wobei eine Markierung, die Informationen bezüglich der Länge anzeigt, an einer Position innerhalb der oberen Fläche jedes Vorsprungs (14) bereitgestellt wird, wobei die Position um eine vorbestimmte Abmessung von der äußeren Umfangsfläche des Stützstifts (11) getrennt ist; und
die Bildverarbeitungsvorrichtung (37) konfiguriert ist, um zu bestimmen, ob der Stützstift (11) um einen vorbestimmten Winkel oder mehr gekippt ist, indem sie auf der Grundlage des Bilderkennungsergebnisses bestimmt, ob eine Markierung auf einem der Vorsprünge (14) durch das obere Ende des Stützstifts (11) verdeckt ist.

3. Zustandsprüfungssystem des Stützstifts (11) der Bauteilmontagemaschine nach Anspruch 2, wobei mehrere Markierungen auf der Oberseite jedes Vorsprungs (14) derart bereitgestellt werden, dass deren Positionen jeweils auf mehreren konzentrischen Kreisen um den axialen Mittelpunkt des Stützstifts (11) liegen;
die Bildverarbeitungsvorrichtung (37) so konfiguriert ist, dass sie die Anzahl der Markierungen unter den mehreren Markierungen jedes Vorsprungs (14) erkennt, die nicht durch das obere Ende des Stützstifts (11) verdeckt sind, und den Neigungswinkel des Stützstifts (11) auf der Grundlage des Bilderkennungsergebnisses bestimmt.

4. Zustandsprüfungssystem für den Stützstift (11) der Bauteilmontagemaschine nach Anspruch 2 oder 3, wobei die Markierung so bereitgestellt wird, dass mindestens eines von der Position in Bezug auf die Oberseite jedes Vorsprungs (14), der Anzahl und der Form geändert werden kann.

5. Zustandsprüfungssystem für den Stützstift (11) der Bauteilmontagemaschine nach Anspruch 1, wobei
auf der Oberseite jedes Vorsprungs (14) ein Abstufungsabschnitt bereitgestellt wird, dessen Farbton oder Farbe sich mit zunehmendem Abstand von der äußeren Umfangsfläche des Stützstifts (11) kontinuierlich oder schrittweise ändert, um Informationen über die Länge anzuzeigen; und
die Bildverarbeitungsvorrichtung (37) so konfiguriert ist, dass sie den Farbton oder die Farbe des Abschnitts innerhalb des Abstufungsabschnitts jedes Vorsprungs (14) erkennt, der nicht durch das obere Ende des Stützstifts (11) verdeckt ist, und dass sie den Neigungswinkel des Stützstifts (11) auf der Grundlage des Bilderkennungsergebnisses bestimmt.

6. Zustandsprüfungssystem für den Stützstift (11) der Bauteilmontagemaschine nach Anspruch 5, wobei der Abstufungsabschnitt an der Oberseite jedes Vorsprungs (14) in austauschbarer Weise mit einem anderen Abstufungsabschnitt bereitgestellt ist.

7. Zustandsprüfungssystem für den Stützstift (11) der Bauteilmontagemaschine nach einem der Ansprüche 1 bis 6, wobei die Bildverarbeitungsvorrichtung (37) so konfiguriert ist, dass sie die Neigungsrichtung des Stützstifts (11) auf der Grundlage des Bilderkennungsergebnisses bestimmt.

8. Zustandsprüfungssystem für den Stützstift (11) der Bauteilmontagemaschine nach einem der Ansprüche 1 bis 7, wobei die Bauteilmontagemaschine den Stützstift (11) hält, indem sie ein am Montagekopf angebrachtes Eingriffshaltewerkzeug mit den Vorsprüngen (14) in Eingriff bringt, wenn der Stützstift (11) automatisch ausgetauscht wird.

9. Zustandsprüfungssystem für den Stützstift (11) der Bauteilmontagemaschine nach einem der Ansprüche 1 bis 8, wobei
die Kamera (32) eine Markierungsabbildungskamera (32) ist, die so konfiguriert ist, dass sie eine Referenzpositionsmarkierung der Leiterplatte abbildet, die Bauteilmontagemaschine so konfiguriert ist, dass sie ein Bild des Stützstifts (11) und der drei oder mehr Vorsprünge (14), die in das Sichtfeld der Kamera (32) fallen, von oben erfasst, wenn der Stützstift (11) automatisch ausgetauscht wird, und
wenn die Bildverarbeitungsvorrichtung (37) auf der Grundlage des Bilderkennungsergebnisses feststellt, dass der Stützstift (11) um einen vorbestimmten Winkel oder mehr gekippt ist, der Vorgang zum Halten des Stützstifts (11) nicht ausgeführt wird und der Stützstift (11) angezeigt wird und/oder ein Bediener durch einen Ton benachrichtigt wird.

10. Zustandsprüfungssystem für einen Stützstift (11) einer Bauteilmontagemaschine, das mit einer Funktion zum automatischen Auswechseln eines Stützstifts (11) ausgestattet ist, der so konfiguriert ist, dass er eine Leiterplatte, auf der Bauteile montiert sind, von unten stützt, umfassend:
eine Kamera (32), die so konfiguriert ist, dass sie ein Bild des Stützstifts (11) von oben erfasst; und
eine Bildverarbeitungsvorrichtung (37), die so konfiguriert ist, dass sie das von der Kamera (32) aufgenommene Bild verarbeitet;
**dadurch gekennzeichnet, dass**
eine Markierung an jeder von drei oder mehr Stellen auf derselben Höhe des Außenumfangs des Stützstifts (11) bereitgestellt wird; und
die Bildverarbeitungsvorrichtung (37), die so konfiguriert ist, dass sie ein von oben aufgenommenes Bild des Stützstifts (11) und der drei oder mehr Markierungen, die in das Sichtfeld der Kamera (32) fallen, verarbeitet, um die Position jeder Markierung zu erkennen und den Neigungswinkel des Stützstifts (11) durch Messen der Abstände zwischen den Markierungen zu bestimmen.

11. Zustandsprüfungssystem für den Stützstift (11) der Bauteilmontagemaschine nach Anspruch 3 oder 10, wobei die Markierungen in 90°-Intervallen an vier konzentrisch um den Stützstift (11) angeordneten Positionen bereitgestellt werden.

## Revendications

1. Système de vérification d'état de broche de soutien (11) d'une machine de montage de composants installée avec une fonction d'échange automatique d'une broche de soutien (11) configurée pour supporter, depuis le dessous, un circuit imprimé sur lequel des composants sont montés, le système de vérification d'état de broche de soutien (11), comprenant :
une caméra (32) configurée pour capturer une image de la broche de soutien (11) depuis le dessus, et
un dispositif de traitement d'image (37) configuré pour traiter l'image capturée par la caméra (32) ;
**caractérisé en ce que**
une protubérance (14) est pourvue à chacune de trois positions ou plus à une dimension prédéterminée au-dessous de l'extrémité supérieure de la périphérie externe de la broche de soutien (11) ; et
le dispositif de traitement d'image (37) est configuré pour traiter l'image capturée depuis le dessus, l'image comprenant la broche de soutien (11) et les trois protubérances ou plus (14) de manière à ce qu'elles soient amenées à tomber dans le champ de vision de la caméra (32), pour reconnaître, dans l'image, de l'information concernant une longueur d'une portion de chaque protubérance (14) qui n'est pas cachée par l'extrémité supérieure de la broche de soutien (11), et pour déterminer si la broche de soutien (11) est inclinée ou non d'un angle prédéterminé ou plus sur la base du résultat de reconnaissance d'image.

2. Système de vérification d'état de broche de soutien (11) de la machine de montage de composants selon la revendication 1, dans lequel
une marque indiquant de l'information concernant la longueur est pourvue à une position dans la face supérieure de chaque protubérance (14), dont la position est séparée d'une dimension prédéterminée de la surface périphérique externe de la broche de soutien (11) ; et
le dispositif de traitement d'image (37) est configuré pour déterminer si la broche de soutien (11) est inclinée ou non d'un angle prédéterminé ou plus en déterminant si une marque sur l'une quelconque des protubérances (14) est cachée ou non par l'extrémité supérieure de la broche de soutien (11) sur la base du résultat de reconnaissance d'image.

3. Système de vérification d'état de broche de soutien (11) de la machine de montage de composants selon la revendication 2, dans lequel
de multiples marques sont pourvues sur la face supérieure de chaque protubérance (14) de telle manière que leurs positions sont respectivement situées sur de multiples cercles concentriques autour du centre axial de la broche de soutien (11) ;
le dispositif de traitement d'image (37) est configuré pour reconnaître le nombre de marques, parmi les multiples marques de chaque protubérance (14), qui ne sont pas cachées par l'extrémité supérieure de la broche de soutien (11), et détermine l'angle d'inclinaison de la broche de soutien (11) sur la base du résultat de reconnaissance d'image.

4. Système de vérification d'état de broche de soutien (11) de la machine de montage de composants selon la revendication 2 ou 3, dans lequel la marque est pourvue de telle sorte qu'au moins un élément parmi la position de chaque protubérance (14) par rapport à la face supérieure, le nombre de protubérances et leur forme peut être modifié.

5. Système de vérification d'état de broche de soutien (11) de la machine de montage de composants selon la revendication 1, dans lequel
une portion de gradation, dont la teinte ou la couleur change de manière continue ou échelonnée à mesure que la distance depuis la surface périphérique externe de la broche de soutien (11) augmente, est pourvue sur la face supérieure de chaque protubérance (14) pour indiquer de l'information concernant la longueur ; et
le dispositif de traitement d'image (37) est configuré pour reconnaître le ton ou la couleur de la portion, dans la portion de gradation de chaque protubérance (14), qui n'est pas cachée par l'extrémité supérieure de la broche de soutien (11), et pour déterminer l'angle d'inclinaison de la broche de soutien (11) sur la base du résultat de reconnaissance d'image.

6. Système de vérification d'état de broche de soutien (11) de la machine de montage de composants selon la revendication 5, dans lequel la portion de gradation est pourvue sur la face supérieure de chaque protubérance (14) de manière échangeable avec une portion de gradation différente.

7. Système de vérification d'état de broche de soutien (11) de la machine de montage de composants selon l'une quelconque des revendications 1 à 6, dans lequel le dispositif de traitement d'image (37) est configuré pour déterminer la direction d'inclinaison de la broche de soutien (11) sur la base du résultat de reconnaissance d'image.

8. Système de vérification d'état de broche de soutien (11) de la machine de montage de composants selon l'une quelconque des revendications 1 à 7, dans lequel la machine de montage de composants maintient la broche de soutien (11) en amenant un outil de maintien d'engagement attaché à la tête de montage à s'engager avec les protubérances (14) lorsque la broche de soutien (11) est échangée automatiquement.

9. Système de vérification d'état de broche de soutien (11) de la machine de montage de composants selon l'une quelconque des revendications 1 à 8, dans lequel
la caméra (32) est une caméra d'imagerie de marque (32) configurée pour imager une marque de position de référence du circuit imprimé,
la machine de montage de composants est configurée pour capturer une image de la broche de soutien (11) et des trois protubérances ou plus (14) qui sont amenées à tomber dans le champ de vision de la caméra (32) depuis le dessus lors de l'échange automatique de la broche de soutien (11), et
quand le dispositif de traitement d'image (37) détermine que la broche de soutien (11) est inclinée d'un angle prédéterminé ou plus sur la base du résultat de reconnaissance d'image, l'opération de maintien de la broche de soutien (11) n'est pas mise en œuvre, et la broche de soutien (11) est affichée et/ou un opérateur est averti par un son.

10. Système de vérification d'état de broche de soutien (11) d'une machine de montage de composants installée avec une fonction d'échange automatique d'une broche de soutien (11) configurée pour supporter, depuis le dessous, un circuit imprimé sur lequel des composants sont montés, comprenant :
une caméra (32) configurée pour capturer une image de la broche de soutien (11) depuis le dessus ; et
un dispositif de traitement d'image (37) configuré pour traiter l'image capturée par la caméra (32) ;
**caractérisé en ce que**
une marque est pourvue à chacun de trois emplacements ou plus, à la même hauteur, de la périphérie externe de la broche de soutien (11) ; et
le dispositif de traitement d'image (37) est configuré pour traiter une image capturée depuis le dessus de la broche de soutien (11) et des trois marques ou plus qui sont amenées à tomber dans le champ de vision de la caméra (32), pour reconnaître la position de chaque marque, et pour déterminer l'angle d'inclinaison de la broche de soutien (11) en mesurant les distances entre les marques.

11. Système de vérification d'état de broche de soutien (11) de la machine de montage de composants selon la revendication 3 ou 10,
dans lequel les marques sont pourvues à des intervalles de 90° à quatre positions situées concentriquement autour de la broche de soutien (11).
